**Europäisches Patentamt**

**European Patent Office**

**Office européen des brevets**

(11) Veröffentlichungsnummer: **0 249 277 B1**

# EUROPÄISCHE PATENTSCHRIFT

(45) Veröffentlichungstag der Patentschrift: **07.04.93**

(51) Int. Cl.⁵: **H05K 3/34**, H01C 1/148

(21) Anmeldenummer: **87201033.5**

(22) Anmeldetag: **02.06.87**

(54) **Passives elektrisches Bauelement.**

(30) Priorität: **07.06.86 DE 3619212**

(43) Veröffentlichungstag der Anmeldung:
**16.12.87 Patentblatt 87/51**

(45) Bekanntmachung des Hinweises auf die
Patenterteilung:
**07.04.93 Patentblatt 93/14**

(84) Benannte Vertragsstaaten:
**AT BE CH DE FR GB IT LI NL SE**

(56) Entgegenhaltungen:
**DE-A- 2 950 450**
**US-A- 2 748 456**

**ELECTRONIC DESIGN, Band 31, Nr. 14, Juli
1983, Seiten 85 - 92, Waseca, MN, Denville,
NJ, US; V. BIANCOMANO: "Surface mounting
profits from material gains."**

**ELEKTRONIK, Band 34, Nr. 14, 12. Juli 1985,
Seiten 42 - 70, München, DE; H. ZELTWAN-
GER: "SMD-Technik in kleinen und mittleren
Unternehmen."**

(73) Patentinhaber: **Philips Patentverwaltung
GmbH
Wendenstrasse 35 Postfach 10 51 49
W-2000 Hamburg 1(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**BE CH FR GB IT LI NL SE AT**

(72) Erfinder: **Düll, Helmut
Hans-Sierks-Strasse 52
W-2240 Heide(DE)**
Erfinder: **Flunkert, Horst, Dr.
Hermann-Börger-Strasse 16
W-2240 Lohe-Rickelshof(DE)**

(74) Vertreter: **Kupfermann, Fritz-Joachim,
Dipl.-Ing. et al
Philips Patentverwaltung GmbH Wendenstrasse 35 Postfach 10 51 49
W-2000 Hamburg 1 (DE)**

EP 0 249 277 B1

## Beschreibung

Die Erfindung betrifft ein passives elektrisches, für SMD-Technik geeignetes Bauelement mit einem zylindrischen oder quaderförmigen Trägerkörper und elektrischen Anschlußkontakten an seinen Enden.

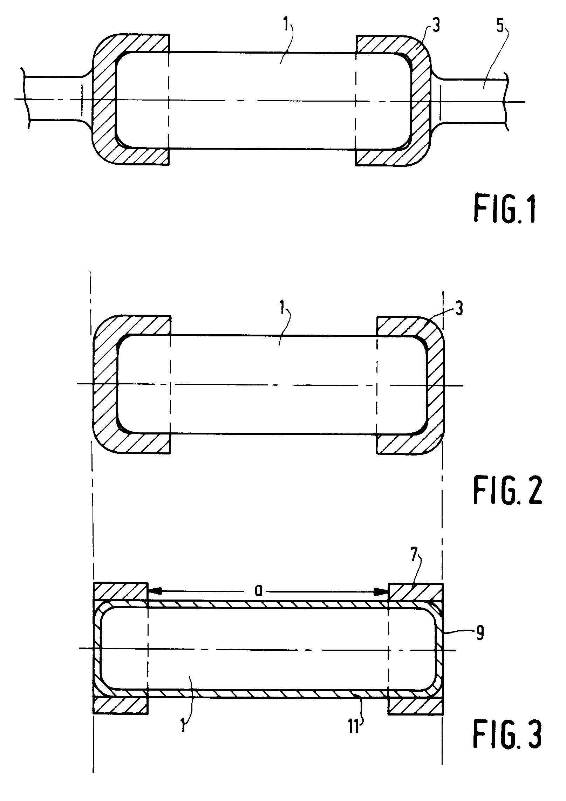

Es ist bekannt, passive elektrische Bauelemente mit z.B. zylindrischen Trägerkörpern mit von den Stirnseiten des Trägerkörpers her aufgebrachten Anschlußkappen zu kontaktieren, an die Anschlußdrähte angeschweißt sind (Figur 1).

Moderne Bestückungsverfahren für Bauelemente nutzen unter Wegfall der Anschlußdrähte die Möglichkeit, die Bauelemente direkt auf Leiterbahnen von gedruckten Schaltungen aufzulöten. Diese Technologie wird unter der Bezeichnung "Surface Mounted Device" (SMD) in immer größerem Umfang genutzt.

Für die SMD-Technik geeignete Bauelemente und dort im besonderen Widerstände und Kondensatoren werden in grundsätzlich zwei verschiedenen Ausführungen hergestellt: als sogenannte Chip-Bauelemente und als sogenannte MELF-Bauelemente. Chip-Bauelemente haben im allgemeinen quaderförmige Trägerkörper mit lötfähigen End- und Stirnflächen. MELF-Bauelemente (MELF = Metal Electrode Face Bonding) gehen von zylindrischen Trägerkörpern mit Anschlußkappen aus, bei denen die Anschlußdrähte weggelassen sind und die Kappen selbst an der Oberfläche durch eine galvanische Behandlung lötfähig gemacht werden und mit diesen Anschlußkappen direkt auf Leiterbahnen von gedruckten Schaltungen verlötet werden (Fig. 2).

Die SMD-Technologie hat den großen Vorteil, daß extrem hohe Packungsdichten von Bauelementen auf Leiterplatten möglich werden. Zur Realisierung immer höherer Packungsdichten werden immer kleinere für die SMD-Technik geeignete Bauelemente erforderlich.

Der Miniaturisierung von passiven Bauelementen der eingangs erwähnten Art sind nun Grenzen gesetzt in doppelter Hinsicht, einmal können Trägerkörper und Anschlußkontakte nicht beliebig verkleinert werden allein aus mechanischen und damit fertigungstechnischen Gründen, zum anderen können derartige Bauelemente aber auch nicht beliebig verkleinert werden im Hinblick auf geforderte elektrische Kenngrößen.

Der Erfindung liegt die Aufgabe zugrunde, das eingangs genannte passive Bauelement derart zu verbessern, daß entweder bei gleich großen Abmessungen verbesserte elektrische Kenndaten erhalten werden oder daß bei gleichbleibenden elektrischen Kenndaten die Länge des Bauelementes reduziert wird.

Diese Aufgabe wird erfindungsgemäß dadurch gelöst, daß die Anschlußkontakte den Trägerkörper an seinen Enden rohrförmig umschließen und die Stirnflächen des Trägerkörpers freilassen.

Nach einer vorteilhaften weiteren Ausgestaltung des Bauelementes nach der Erfindung lassen die Anschlußkontakte die Stirnflächen des Trägerkörpers vollständig frei. Hiermit ist der Vorteil verbunden, daß für die Anschlußkontakte einfach zu fertigende Metallröhrchen eingesetzt werden können, die als Hülsen auf den Trägerkörper aufgeschoben und mit ihm verlötet werden. Bislang ging die Fachwelt von der Annahme aus, daß es bei den sogenannten MELF-Bauelementen und insbesondere bei Schichtwiderständen unbedingt erforderlich sei, eine auf dem Trägerkörper befindliche elektrische Funktionsschicht, also z.B. die Widerstandsschicht, durch Anschlußkontakte in Form von an den Enden des Widerstandskörpers abgeschlossenen Endkappen schützen zu müssen. Es hat sich nun überraschenderweise gezeigt, daß ein ausreichender Schutz der an den Stirnflächen des Trägerkörpers befindlichen Widerstandsschicht schon allein durch eine z.B. galvanisch aufgebrachte Metallschicht erreicht werden kann, die ohnehin nach Anbringen der Anschlußkontakte auf diesen angebracht werden muß, um auf den Anschlußkontakten anschließend eine Lötschicht anbringen zu können. Da die Widerstandsschicht eine elektrisch leitende Schicht ist, lassen sich auch auf ihr weitere galvanische Schichten anbringen.

Nach weiteren vorteilhaften Ausgestaltungen des Bauelementes nach der Erfindung sind aus einer Metallteilchen enthaltenden Suspension Dickschicht-Anschlußkontakte oder es sind galvanisch abgeschiedene Dünnschicht-Anschlußkontakte auf dem Trägerkörper angebracht. Hiermit ist der Vorteil verbunden, daß auch Anschlußkontakte kleinster Abmessungen für sogenannte Mikro-Bauelemente, deren Längenabmessung in der Größenordnung von 2 mm bei einem Durchmesser von 0,8 mm liegt, noch präzise gefertigt werden können.

Nach einer weiteren vorteilhaften Ausgestaltung des passiven Bauelementes nach der Erfindung umgreifen die Anschlußkontakte die Stirnflächen des Trägerkörpers an ihrem Rand und lassen den Innenbereich der Stirnflächen frei. Hiermit ist bei Verarbeitung insbesondere von Metallhülsen als Anschlußkontakt der Vorteil verbunden, daß die Metallhülsen mit einem einseitig leicht umgebördelten Rand vorgefertigt werden können.

Beim Kontaktieren der Trägerkörper ergibt sich dann der Vorteil, daß der einseitig leicht umgebördelte Rand der Metallhülsen als Anschlag für den Trägerkörper wirkt, der Trägerkörper also nicht durch die Metallhülsen hindurchgeschoben werden kann.

Es kann jedoch auch so vorgegangen werden, daß zunächst Metallhülsen ohne einseitig leicht umgebördel-

2

ten Rand über den Trägerkörper geschoben werden und der Rand erst während des Kontaktierungsprozesses so verformt wird, daß er den Rand des Trägerkörpers so umgreift, daß der Innenbereich der Stirnflächen des Trägerkörpers frei bleibt. Es kann mit Vorteil außerdem so verfahren werden, daß bereits mit einem leicht umgebördelten Rand vorgefertigte Metallhülsen zum Kontaktieren der Trägerkörper eingesetzt werden und daß der leicht umgebördelte Rand der Metallhülsen während des Kontaktierungsprozesses noch einmal durch Stauchen oder Pressen in Richtung auf den Trägerkörper hin verformt wird. Auf diese Weise können Längentoleranzen, wie sie bei der Herstellung von insbesondere keramischen Trägerkörpern, bedingt durch deren Herstellungsprozess, auftreten, ausgeglichen werden.

Ein besonderer, mit der Erfindung erzielter Vorteil ist darin zu sehen, daß bei vorgegebener Länge der Bauelemente ein längerer Bereich des Trägerkörpers frei von Anschlußkontakten bleibt, als es bei einem Bauelement der Fall ist, dessen stirnseitige Anschlußkontakte in Form von Anschlußkappen ausgebildet sind. Da mit der Ausbildung der Anschlußkontakte nach der Erfindung auf den Teil der bekannten Anschlußkontakte, die die Stirnflächen des Trägerkörpers bedecken, verzichtet wird, wird die Wandstärke des Kappenbodens als freie Länge zwischen den Anschlußkontakten gewonnen, die freie Länge des Trägerkörpers wird bei gleichen Bauelementabmessungen also zumindest um zweimal Kappenbodendicke größer.

Dies hat z.B. ganz besondere Vorteile bei der Herstellung von zylindrischen Schichtwiderständen. Die Metallschichtfläche von Schichtwiderständen wird durch Einschneiden einer Wendel, z.B. mit Hilfe von Lasern oder Schleifscheiben auf einen gewünschten Widerstandswert abgeglichen. Da die freie Länge zwischen den Anschlußkontakten mit den erfindungsgemäßen Anschlußkontakten größer wird im Vergleich zu bekannten Widerständen gleicher Gesamtbauelementlänge, die als Anschlußkontakte Anschlußkappen haben, steht für einen Abgleichvorgang also deutlich mehr Fläche zur Verfügung. Bei der Herstellung von hochohmigen Schichtwiderständen spielt die Anzahl der mit dem Abgleichvorgang hergestellten Wendel eine wesentliche Rolle.

Ausführungsbeispiele der Erfindung sind in der Zeichnung dargestellt. Es zeigen:
Figuren 1 und 2 passive zylindrische Bauelemente nach dem Stand der Technik,
Figuren 3 und 4 passive zylindrische elektrische Bauelemente gemäß der Erfindung im Schnitt mit Anschlußkontakten unterschiedlicher Form,
Figur 5 Ausschnitt eines Anschlußkontaktes gemäß Figur 4,
Figuren 6 und 7 Ausschnitte eines Anschlußkontaktes gemäß Figur 4 in durch den Kontaktierungsprozeß bedingten unterschiedlichen Formen,
Figur 8 Ausschnitt eines im Schnitt schematisch dargestellten fertigen Schichtwiderstandes nach der Erfindung.

In den Figuren 1 und 2 sind passive elektrische Bauelemente mit zylindrischen Trägerkörpern 1 und stirnseitigen Anschlußkontakten 3 in Form von Metallkappen dargestellt, wie sie aus dem Stand der Technik bekannt sind.

Das Bauelement nach Figur 1 zeigt an den Anschlußkontakten 3 Anschlußdrähte 5, die für die Montage der Bauelemente abgebogen und in Bohrungen von gedruckten Schaltungen eingelötet werden.

Figur 2 zeigt ein MELF-Bauelement, bei dem als Anschlußkontakte 3 nur noch Metallkappen vorhanden sind, die für die Montage der Bauelemente mit Leiterbahnen von gedruckten Schaltungen direkt verlötet werden.

In den Figuren 3 bis 8 sind passive elektrische Bauelemente gemäß der Erfindung im Schnitt dargestellt.

Figur 3 zeigt ein passives elektrisches Bauelement mit zylindrischem Trägerkörper 1, der mit Anschlußkontakten 7 versehen ist, die den Trägerkörper 1 rohrförmig umschließen und die Stirnflächen 9 des Trägerkörpers 1 vollständig freilassen. Diese Anschlußkontakte 7 können in Form von Metallhülsen auf den Trägerkörper 1 aufgeschoben und mit ihm verlötet sein, sie können jedoch auch aus einer Metallteilchen enthaltenden Suspension als Dickschichtkontakt oder als galvanisch abgeschiedener Dünnschichtkontakt ausgebildet sein. Aus dem Vergleich der Figuren 2 und 3 zeigt sich, daß durch den Verzicht auf den Kappenboden der bekannten Anschlußkontakte die Wandstärke des Kappenbodens als freie Länge zwischen den Anschlußkontakten 7 gewonnen wird, die freie Länge a des Trägerkörpers 1 wird bei gleichen Bauelementabmessungen also um mindestens zweimal Kappenbodendicke größer. Dies hat, wie weiter oben bereits beschrieben, insbesondere bei der Herstellung von Schichtwiderständen den Vorteil, daß für einen Abgleichvorgang durch Einschneiden einer Wendel in eine auf dem Trägerkörper 1 befindliche Widerstandsschicht 11 bedeutend mehr Fläche zur Verfügung steht, was insbesondere bei der Herstellung von hochohmigen Schichtwiderständen von Bedeutung ist.

Bei gleichen Bauelement-Abmessungen können auf diese Weise die elektrischen Kenndaten der erfindungsgemäßen Bauelemente gegenüber den bekannten Bauelementen nicht unwesentlich verbessert werden, wie sich aus den Vergleichswerten für den Widerstandswert $R_N$ aus der nachfolgenden Tabelle ergibt. Aus der Tabelle wird überdies deutlich, daß bei Widerständen mit kleinen Abmessungen der Widerstandswert $R_N$ für Widerstände nach der Erfindung überproportional anwächst, worin ein wesentlicher Vorteil der mit Anschlußkontakten gemäß der Erfindung versehenen Bauelemente liegt.

**Tabelle**

| | Schichtwiderstand mit kappenförmigen Anschlußkontakten nach dem Stand der Technik | | | Schichtwiderstand mit hülsenförmigen Anschlußkontakten nach der Erfindung | | |
|---|---|---|---|---|---|---|
| | Durchmesser des Trägerkörpers [mm] | Gesamt Länge [mm] | Widerstandswert $R_N$ * [Ω] | Durchmesser des Trägerkörpers [mm] | Gesamt Länge [mm] | Widerstandswert $R_N$ * [Ω] |
| | 1,0 | 3,6 | $650 \cdot 10^3$ | 1,0 | 3,6 | $850 \cdot 10^3$ |
| | 0,8 | 3,0 | $300 \cdot 10^3$ | 0,8 | 3,0 | $420 \cdot 10^3$ |
| | 0,8 | 2,0 | $80 \cdot 10^3$ | 0,8 | 2,0 | $210 \cdot 10^3$ |
| | 0,6 | 1,7 | $10 \cdot 10^3$ | 0,6 | 1,7 | $80 \cdot 10^3$ |

\* Ausgehend von einem gleichen Flächenwiderstand von 1000 Ω bei gleicher Wendelsteigung von 0,2 mm bei 0,08 mm Schnittbreite

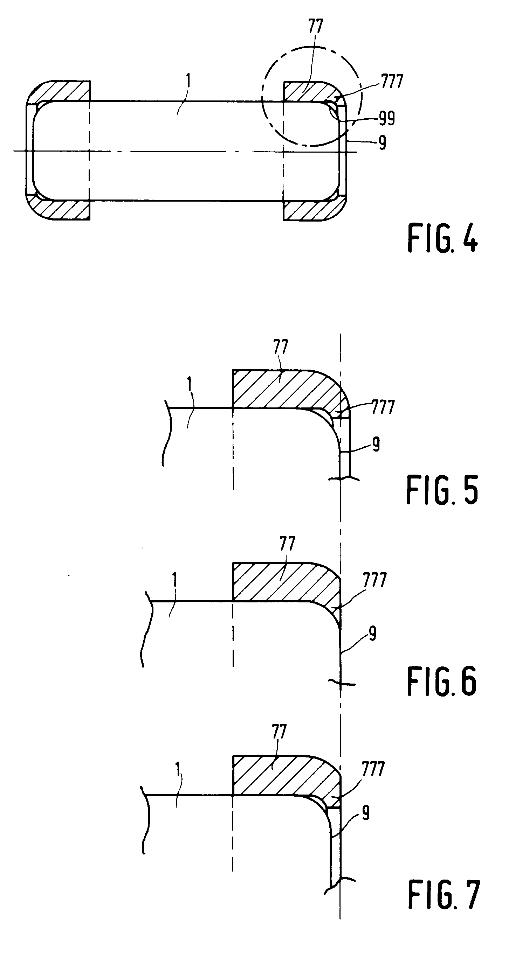

In Figur 4 mit Ausschnitt gemäß Figur 5 ist ein passives elektrisches Bauelement nach der Erfindung mit Anschlußkontakten 77 dargestellt, die sich von den Anschlußkontakten 7 gemäß Figur 3 dadurch unterscheiden, daß sie die Stirnflächen 9 an deren Rand 99 umgreifen und den Innenbereich der Stirnflächen 9 freilassen. Als Anschlußkontakte 77 werden für diese Ausführungsform z.B. mit einem einseitig leicht umgebördelten Rand 777 vorgefertigte Metallhülsen eingesetzt. Hierdurch ergibt sich der Vorteil, daß der einseitig leicht umgebördelte Rand 777 als Anschlag für den Trägerkörper 1 wirkt. Werden als Anschlußkontakte Metallhülsen mit einseitig umgebördeltem Rand eingesetzt, ergibt sich der weitere Vorteil, daß während des Kontaktierungsprozesses Längentoleranzen, wie sie sich bei der Fertigung von keramischen Trägerkörpern ergeben, ausgeglichen werden können.

In den Figuren 6 und 7 ist diese Anpassung der Anschlußkontakte 77 an unterschiedliche Längen des Trägerkörpers 1 schematisch im Ausschnitt dargestellt.

Figur 6 zeigt ein Bauelement mit einem Trägerkörper 1 mit maximaler Länge, bei dem der umgebördelte Rand 777 des Anschlußkontaktes 77 während des Kontaktierungsprozesses so deformiert wurde, daß die Gesamtlänge des erhaltenen, kontaktierten Bauelementes der Länge des Trägerkörpers 1 entspricht.

Figur 7 zeigt ein Bauelement mit einem Trägerkörper 1 mit minimaler Länge, bei dem der umgebördelte Rand 777 des Anschlußkontaktes 77 während des Kontaktierungsprozesses im Vergleich zu dem umgebördelten Rand 777 gemäß Figur 6 weniger deformiert wurde, so daß im Endergebnis trotz eines kürzeren Trägerkörpers 1 wieder eine vorgegebene Gesamtlänge des Bauelementes erreicht wird.

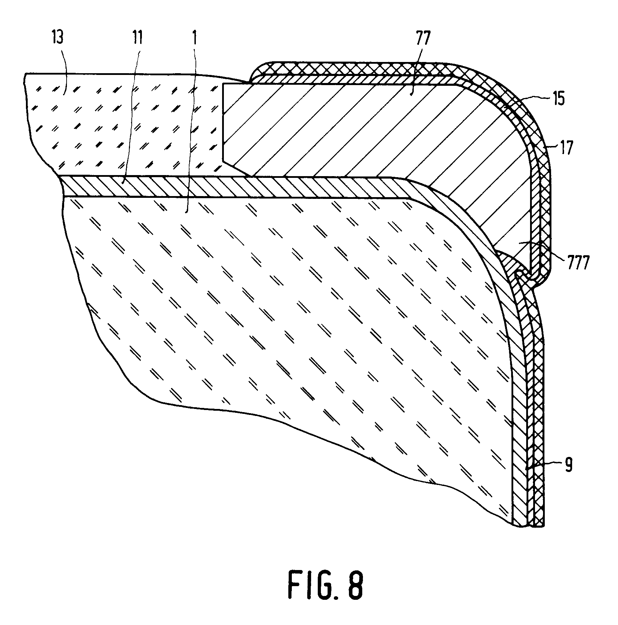

In Figur 8 ist im Ausschnitt ein fertiger Schichtwiderstand mit Anschlußkontakten gemäß der Erfindung dargestellt.

Die elektrische Funktionsschicht in Form einer Widerstandsschicht 11 ist im Bereich zwischen den Anschlußkontakten 77 mit umgebördelten Rändern 777 mit einer Isolierschicht 13 aus z.B. einem isolierenden Kunstharz bedeckt. Bei der anschließenden Ausrüstung der Anschlußkontakte 77, 777 mit einem lötfähigen Überzug 15,17, der nach dem heutigen Stand der Technik durch einen Mehrschichtenaufbau z.B. aus einer galvanisch angebrachten Kupferschicht 15 und einer Lötschicht 17, z.B. aus Zinn oder Blei-Zinn realisiert wird, werden die von den Anschlußkontakten 77, 777 freigelassenen Stirnflächen 9 des Trägerkörpers 1 ebenfalls galvanisch mitbeschichtet, da die auf den Stirnflächen 9 liegende Widerstandsschicht 11 elektrisch leitend ist. Der durchgehende Überzug 15, 17 schließt die Funktionsschicht 11 hermetisch gegen Umwelteinflüsse ab und es bedarf des zusätzlichen Schutzes durch einen die Stirnflächen des Trägerkörpers bedeckenden Boden an den Anschlußkontakten nicht, um Bauelemente guter Qualität zu realisieren, z.B. Bauelemente, die eine gute Alterungsbeständigkeit aufweisen.

Als Ausführungsbeispiel ist die Herstellung von elektrischen Schichtwiderständen beschrieben worden. Die Anschlußkontakte sind jedoch gleichermaßen für die Herstellung von Kapazitäten und Induktivitäten mit zylinder- oder quaderförmigen Trägerkörpern einsetzbar.

**Patentansprüche**

1. Passives elektrisches, für SMD-Technik geeignetes Bauelement mit einem zylindrischen oder quaderförmigen Trägerkörper und elektrischen Anschlußkontakten an seinen Enden, dadurch gekennzeichnet, daß die Anschlußkontakte (77, 777) den Trägerkörper (1) an seinen Enden röhrförmig umschließen und die Stirnflächen (9) des Trägerkörpers freilassen.

2. Passives elektrisches Bauelement nach Anspruch 1, dadurch gekennzeichnet, daß die Anschlußkontakte (77, 777) die Stirnflächen (9) des Trägerkörpers (1) vollständig freilassen.

3. Passives elektrisches Bauelement nach Anspruch 1, dadurch gekennzeichnet, daß die Anschlußkontakte (77, 777) die Stirnflächen (9) des Trägerkörpers (1) an ihrem Rand (99) umgreifen und den Innenbereich der Stirnflächen (9) freilassen.

4. Passives elektrisches Bauelement nach mindestens einem der vorhergehenden Ansprüche, dadurch gekennzeichnet, daß die Anschlußkontakte (77, 777) als gesondert hergestellte zylindrische Metallhülsen ausgebildet sind.

5. Passives elektrisches Bauelement nach mindestens einem der vorhergehenden Ansprüche, dadurch gekennzeichnet, daß aus einer Metallteilchen enthaltenden Suspension Dickschicht-Anschlußkontakte (77, 777) auf dem Trägerkörper angebracht sind.

6. Passives elektrisches Bauelement nach mindestens einem der vorhergehenden Ansprüche, dadurch gekennzeichnet, daß galvanisch abgeschiedene Dünnschicht-Anschlußkontakte (77, 777) auf dem Trägerkörper (1) angebracht sind.

**7.** Passives elektrisches Bauelement nach den Ansprüchen 1 bis 6, <u>dadurch gekennzeichnet,</u> daß der Trägerkörper aus elektrisch isolierender Keramik besteht.

**8.** Passives elektrisches Bauelement nach den Ansprüchen 1 bis 6, <u>dadurch gekennzeichnet,</u> daß der Trägerkörper (1) aus dielektrischer Keramik besteht.

**9.** Passives elektrisches Bauelement nach den Ansprüchen 1 bis 6, <u>dadurch gekennzeichnet,</u> daß der Trägerkörper (1) aus einem Ferrit besteht.

**10.** Passives elektrisches Bauelement nach Anspruch 7, <u>dadurch gekennzeichnet,</u> daß es als elektrischer Widerstand ausgebildet ist.

**11.** Passives elektrisches Bauelement nach Anspruch 8, <u>dadurch gekennzeichnet,</u> daß es als Kondensator ausgebildet ist.

**12.** Passives elektrisches Bauelement nach Anspruch 9, <u>dadurch gekennzeichnet,</u> daß es als Spule ausgebildet ist.

**Claims**

**1.** A passive electric component suitable for SMD-technique and having a cylindrical supporting member or a supporting member in the form of a rectangular parallelepiped and having electric connection elements at its ends, characterized in that the connection elements (77, 777) surround the supporting member (1) at its ends in a tubular manner and do not cover the end faces (9) of the supporting member.

**2.** A passive electric component as claimed in Claim 1, characterized in that the connection elements (77, 777) leave the end faces (9) of the supporting member (1) entirely free.

**3.** A passive electric component as claimed in Claim 1, characterized in that the connection elements (77, 777) embrace the end faces (9) of the supporting member (1) at its edge (9) and do not cover the inner area of the end faces (9).

**4.** A passive electric component as claimed in at least one of the preceding Claims, characterized in that the connection elements (77, 777) are formed as individually manufactured cylindrical metal sleeves.

**5.** A passive electric component as claimed in at least one of the preceding Claims, characterized in that thick-film connection elements (77, 777) from a suspension containing metal particles are provided on the supporting member.

**6.** A passive electric component as claimed in at least one of the preceding Claims, characterized in that electro-plated thin-film connection elements (77, 777) are provided on the supporting member (1).

**7.** A passive electric component as claimed in Claims 1 to 6, characterized in that the supporting member consists of electrically insulating ceramic.

**8.** A passive electric component as claimed in Claims 1 to 6, characterized in that the supporting member (1) consists of dielectric ceramic.

**9.** A passive electric component as claimed in Claims 1 to 6, characterized in that the supporting member (1) consists of a ferrite.

**10.** A passive electric component as claimed in Claim 7, characterized in that it is an electric resistor.

**11.** A passive electric component as claimed in Claim 8, characterized in that it is a capacitor.

**12.** A passive electric component as claimed in Claim 9, characterized in that it is an inductor.

**Revendications**

**1.** Composant électrique passif, convenant dur la technique SMD à corps de support cylindriques ou parallélépipédiques et à contacts de connexion électriques à ses extrémités, caractérisé en ce que les contacts de connexion (77, 777) enserrent le corps de support (1) de manière tubulaire à ses extrémités et laissent les faces d'about (9) de ce corps de support dégagées.

**2.** Composant électrique passif suivant la revendication 1, caractérisé en ce que les contacts de connexion (77, 777) laissent les faces d'about (9) du corps de support (1) entièrement dégagées.

**3.** Composant électrique passif suivant la revendication 1, caractérisé en ce que les contacts de connexion (77,777) enserrent les faces d'about (9) du corps de support (1) au niveau de leur bord (99) et laissent la zone intérieure de ces faces d'about (9) dégagée.

**4.** Composant électrique passif suivant au moins une des revendications précédentes, caractérisé en ce que les contacts de connexion (77, 777) ont la forme de viroles métalliques cylindriques fabriquées séparément.

**5.** Composant électrique passif suivant au moins une des revendications précédentes, caractérisé en ce que des contacts de connexion en couche épaisse (77, 777) sont appliqués sur le corps de support à partir d'une suspension contenant des particules métalliques.

**6.** Composant électrique passif suivant au moins une des revendications précédentes, caractérisé en ce que des contacts de connexion en couche mince déposés par voie galvanique (77, 777) sont appliqués sur le corps de support (1).

**7.** Composant électrique passif suivant l'une quelconque des revendications 1 à 6, caractérisé en ce que le corps de support est fait d'une céramique électriquement isolante.

**8.** Composant électrique passif suivant l'une quelconque des revendications 1 à 6, caractérisé en ce que le corps de support (1) est fait d'une céramique diélectrique.

**9.** Composant électrique passif suivant l'une quelconque des revendications 1 à 6, caractérisé en ce que le corps de support (1) est fait d'une ferrite.

**10.** Composant électrique passif suivant la revendication 7, caractérisé en ce qu'il a la forme d'une résistance électrique.

**11.** Composant électrique passif suivant la revendication 8, caractérisé en ce qu'il a la forme d'un condensateur.

**12.** Composant électrique passif suivant la revendication 9, caractérisé en ce qu'il a la forme d'une bobine.

FIG.1

FIG.2

FIG.3

FIG. 4

FIG. 5

FIG. 6

FIG. 7

FIG. 8